(19) Europäisches Patentamt
European Patent Office
Office européen des brevets

(11) Numéro de publication: **0 185 825 B1**

# (12) FASCICULE DE BREVET EUROPEEN

(45) Date de publication du fascicule du brevet: **01.03.89**

(51) Int. Cl.⁴: **C 07 B 61/02**, C 07 D 211/94, G 01 N 33/24

(21) Numéro de dépôt: **84402263.2**

(22) Date de dépôt: **09.11.84**

(54) **Procédé de polarisation magnétique des noyaux d'un solvant par résonance magnétique d'un radical nitroxyde dissous dans le solvant.**

(43) Date de publication de la demande:
**02.07.86 Bulletin 86/27**

(45) Mention de la délivrance du brevet:
**01.03.89 Bulletin 89/9**

(84) Etats contractants désignés:
**DE GB IT**

(56) Documents cités:
**FR-A- 2 063 416**
**US-A- 4 332 946**

**CHEMICAL ABSTRACTS, vol. 96, no. 5, 1 février 1982, page 645, no. 35028z, Columbus, Ohio, US; Y. YOST et al.: "Application of spin labeling to drug assays. I. Synthesis of 2,2,6,6-tetramethylpiperidin-4-one-1-oxyl-15N-d16" & J. LABELLED COMPD. RADIOPHARM. 1981, 18(8), 1089-1097**
**TETRAHEDRON, vol. 29, no. 22, 1973, pages 3639-3647, Pergamon Press, Oxford, GB; R. CHIARELLI et al.: "Nitroxydes-LVI. Synthèses de radicaux nitroxydes deutériés"**

(73) Titulaire: **COMMISSARIAT A L'ENERGIE ATOMIQUE, 31/33, rue de la Fédération, F-75015 Paris (FR)**

(72) Inventeur: **Besson, René, 4 rue des Champs Roches, F-38240 Meylan (FR)**
Inventeur: **Chiarelli, Robert Paul, Grande Rue, F-38660 Le Touvet (FR)**
Inventeur: **Rassat, André, Ramage Poisat, F-38320 Eybens (FR)**
Inventeur: **Salvi, Antoine, 20, rue Gagriel Péri, F-38600 Fontaine (FR)**
Inventeur: **Secourgeon, Liliane, 3, rue de l'ancienne ferme, F-38120 Saint Egreve (FR)**

(74) Mandataire: **Mongrédien, André et al, c/o BREVATOME 25, rue de Ponthieu, F-75008 Paris (FR)**

EP 0 185 825 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un procédé de polarisation dynamique des noyaux d'un solvant, utilisant les techniques de la résonance magnétique nucléaire de radicaux libres nitroxydes, stables en solution. Elle s'applique à la magnétométrie et à la gyrométrie en champ magnétique faible.

On sait que dans les magnétomètres à champ terrestre et les gyromètres utilisant la résonance magnétique des noyaux, le principal problème est celui de la polarisation, c'est-à-dire de l'orientation forcée des spins, ou moments cinétiques des noyaux, notamment des protons du solvant dans lequel le radical est dissous en proportion convenable.

Cette polarisation peut être obtenue, conformément au brevet français n° 1 174 136 intitulé: «Perfectionnement aux méthodes de mesure des champs magnétiques faibles par résonance magnétique» déposé le 6 avril 1957, au nom du demandeur, par couplage de l'électron non apparié d'un radical libre, dont la raie de résonance paramagnétique électronique est saturée par un champ de haute fréquence convenable avec les noyaux du solvant.

Les radicaux libres nitroxydes utilisés jusqu'à présent possédaient un atome d'azote 14. Parmi ces radicaux on peut citer ceux présentant la formule développée:

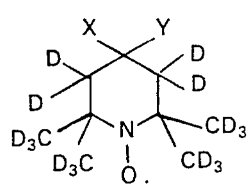

dans laquelle X représente D, Y représente D ou OD ou dans laquelle X et Y représentent O lié au cycle du radical par une double liaison. L'application à la magnétométrie en champ faible du tétraméthyl-2,2,6 pipéridone-4, oxyle-1 deutérié, couramment appelé TANO deutérié, a d'ailleurs fait l'objet d'un brevet français n° 2 063 416 intitulé «Polarisation des noyaux d'un solvant par pompage électronique» déposé au nom du demandeur le 15 octobre 1969.

En champ magnétique élevé (3000 gauss), le diagramme des niveaux électroniques d'un radical nitroxyde $^{14}N$ est tel que trois transitions sont permises, donnant une structure hyperfine à trois raies de résonance.

En champ magnétique très faible (inférieur à 10 gauss), zone opérationnelle des magnétomètres, seules deux transitions sont autorisées. La fréquence de résonance de ces transitions que l'on sature pour provoquer l'effet de polarisation dynamique des noyaux du solvant est fonction de différents paramètres (nature du solvant, nature du radical). D'autre part, la phase du signal nucléaire obtenue par saturation de la «raie haute» est en opposition de celle obtenue par saturation de la «raie basse». Cet effet est utilisé dans les sondes de magnétomètre et de gyromètre.

De tels dispositifs ont été décrits dans un brevet français n° 2 098 624 déposé au nom du demandeur le 22 juillet 1970 et intitulé «Magnétomètre à résonance magnétique nucléaire», et dans un autre brevet français n° 2 213 500 déposé au nom du demandeur le 20 septembre 1972 et intitulé «Procédé de mesure d'une vitesse de rotation et gyromètre de mise en œuvre».

Pour augmenter le coefficient de polarisation dynamique des noyaux d'un solvant, notamment des protons, donc pour obtenir un signal de sortie égal avec une puissance haute fréquence moindre, l'invention envisage le remplacement, dans des radicaux nitroxydes, du type de ceux qui présentent la formule développée:

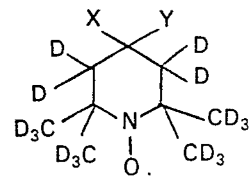

dans laquelle X représente D, Y représente D ou OD ou dans laquelle X et Y représentent O lié au cycle du radical par une double liaison, de l'azote 14 par de l'azote 15.

Aussi, l'invention a pour objet un procédé de polarisation magnétique en champ faible des noyaux d'un solvant par saturation d'une raie de résonance magnétique électronique d'un radical nitroxyde à azote 15 ci-dessus, dissous dans le solvant.

Dans la suite du texte, en vue d'une simplification, le radical tétraméthyl-2,2,6,6 pipéridone-4, oxyle-1 deutérié, azote 15, selon l'invention, sera appelé TANO $^{15}N$ deutérié (TANO étant l'abréviation de triacétonamine nitroxyde); le radical tétraméthyl-2,2,6,6 pipéridine, oxyle-1, deutérié, azote 15, selon l'invention, sera appelé TANANE $^{15}N$ deutérié; le radical tétraméthyl 2,2,6,6 pipéridinol-4, oxyle-1, azote 15, selon l'invention, sera appelé TANOL $^{15}N$ deutérié.

Le diagramme des niveaux électroniques d'un radical nitroxyde à azote 15 est tel qu'en champ magnétique élevé deux transitions sont seulement permises, donnant une structure hyperfine à deux raies de résonance, avec un couplage électron célibataire noyau d'azote 15 différent du couplage électron célibataire noyau d'azote 14.

Cela présente plusieurs avantages en magnétométrie et en gyrométrie. En particulier, le spectre électronique en champ très faible est toujours composé de deux raies. Mais ces dernières sont plus fines, de saturation plus aisée, procurant ainsi un gain d'énergie appréciable. De plus, cela permet l'accès, par le jeu des solvants et des radicaux à azote 15 à une autre gamme de fréquences de résonance électronique.

D'autres caractéristiques et avantages de l'invention ressortiront mieux de la description qui va suivre, donnée à titre purement illustratif et non limitatif, en référence aux figures annexées dans lesquelles:

– la figure 1 représente les raies de résonance en champ faible du radical TANO $^{14}N$ deutérié, c'est-à-dire la courbe du signal nucléaire S en fonction de la fréquence ν (exprimée en mégahertz) (figure 1a) et du radical TANO $^{15}N$ deutérié (figure 1b) dissous dans du méthanol, à une concentration $10^{-3}$ molaire;

– la figure 2 représente schématiquement une sonde de magnétomètre, sans axe interdit, et

– la figure 3 représente le gain en puissance haute fréquence, c'est-à-dire la courbe du signal nucléaire S en fonction de la puissance haute fréquence P (exprimée en watt) pour le radical TANO $^{14}N$ deutérié (figure 3a) et le radical TANO $^{15}N$ deutérié (figure 3b).

Sur la figure 1a sont représentées les raies de résonance en champ faible du radical TANO $^{14}N$ deutérié et sur la figure 1b les raies de résonance en champ faible du radical TANO $^{15}N$ deutérié, les deux radicaux étant dissous à une concentration $10^{-3}M$ dans du méthanol. D'après ces courbes on constate d'une part, que les raies de résonance du TANO $^{15}N$ deutérié sont plus fines, mieux résolues que celles du TANO $^{14}N$ deutérié, donc plus facilement saturées, ce qui entraîne un gain d'énergie appréciable en puissance de saturation et d'autre part, un déplacement en fréquence des raies de résonance.

En effet, la gamme des fréquences de polarisation des noyaux s'étend de 60 à 70 MHz pour le TANO $^{14}N$ deutérié et de 55 à 65 MHz pour le TANO $^{15}N$ deutérié suivant le solvant utilisé. Ceci permet en utilisant la «raie haute» de l'un des deux radicaux et la «raie basse» de l'autre d'obtenir une gamme dite de «croisement de fréquence» plus étendue que lorsque l'on utilise des radicaux nitroxydes à azote 14 seuls.

L'augmentation de la gamme de «croisement de fréquence» est avantageuse en gyrométrie où l'on fonctionne en présence d'un champ créé artificiellement, le champ directeur, dont la direction est celle de l'axe autour duquel on mesure la rotation. Il est en effet important que le champ magnétique terrestre soit le plus petit possible par rapport au champ directeur. Pour cette raison on utilise un champ directeur de 2 oersted minimum ($2.10^{-4}$ Tesla).

Les radicaux nitroxydes à azote 15 peuvent être utilisés avec profit, comme les radicaux nitroxydes à azote 14, dissous dans la plupart des solvants organiques ne détruisant pas le radical. L'utilisation de ces radicaux dans l'eau ou dans l'eau dopée par du chlorure de lithium est aussi possible.

Sur la figure 2, on a représenté une sonde d'un magnétomètre sans axe interdit contenant de nombreux éléments décrits dans le brevet français nº 2 213 500.

Sur la figure 2a, on a représenté une coupe schématique d'une sonde. La sonde est constituée de deux ensembles similaires 2 et 4, alignés suivant l'axe ZZ'; chaque ensemble se compose d'une bobine 6 et 6' entourant des échantillons 8 et 8'; la section droite des bobines 6 et 6' peut être notamment triangulaire; les échantillons sont contenus dans deux récipients indépendants 10 et 10' qui peuvent avantageusement avoir la forme de deux flacons symétriques, respectivement 14 et 15, et 14' et 15', de sorte que, juxtaposés, ils délimitent un espace dans lequel les bobines 6 et 6' peuvent être disposées. La cavité résonnante d'excitation comprend un conducteur 12 relié au conducteur initial du câble coaxial 13 et une enveloppe extérieure 18.

Dans les sondes uniaxiales telles que celle qui est représentée sur la figure 2a, les bobines 6 et 6' sont bobinées en sens contraire de sorte que les signaux parasites qui y sont induits se compensent mutuellement; au contraire, les signaux utiles provenant des forces électromotrices créées par les phénomènes de résonance nucléaire s'ajoutent. Un tel bobinage est illustré sur la figure 2b.

Il est à noter que le résultat ci-dessus n'est toutefois atteint que si la résultante macroscopique des moments magnétiques des noyaux d'un des échantillons est opposée à la résultante macroscopique des moments magnétiques des noyaux de l'autre échantillon. Dans le mode de réalisation illustré, comportant une seule source d'excitation à très haute fréquence, il faut que ces effets opposés interviennent en réponse à une excitation qui s'effectue à la même fréquence pour les deux échantillons.

Pour obtenir un tel résultat on peut par exemple utiliser un échantillon 8 constitué par du TANO $^{15}N$ deutérié dissous, à une concentration $10^{-3}$ molaire, dans un solvant constitué de 92% en volume de diméthoxyéthane et de 8% d'eau et un échantillon 8' par du TANO $^{15}N$ deutérié dissous, à une concentration $10^{-3}$ molaire, dans du méthanol.

Avec une telle sonde d'un magnétomètre, c'est la «raie haute» de l'échantillon 8 qui est excitée, alors que c'est la «raie basse» de l'échantillon 8' qui est excitée.

Le «croisement de fréquence» de ces deux transitions s'effectue pour un champ de 0,4 oersted avec une fréquence de pompage électronique de 58,9 MHz.

Pour des sondes de magnétomètres, le fait d'utiliser des radicaux nitroxydes à azote 15, selon l'invention, permet d'obtenir un gain en puissance haute fréquence. Ceci est illustré par les courbes de la figure 3.

Les figures 3a et 3b représentent respectivement le signal nucléaire S obtenu aux bornes des bobines 6 et 6' de la sonde, en fonction de la puissance haute fréquence P, pour le radical TANO $^{14}N$ deutérié et le radical TANO $^{15}N$ deutérié. On constate que pour une même valeur du signal nucléaire, la valeur de la puissance haute fréquence est plus faible pour des solutions contenant du TANO $^{15}N$ deutérié, ce qui correspond à un coefficient de polarisation dynamique des noyaux du solvant plus important.

On va maintenant donner les procédés de fabrication des radicaux TANO $^{15}N$ deutérié, TANOL $^{15}N$ deutérié et TANANE $^{15}N$ deutérié. Ces radi-

caux sont obtenus à partir de la triacétonamine deutériée, azote 15. Celle-ci est obtenue en faisant réagir en présence d'un agent déshydratant et complexant tel que le chlorure de calcium, de l'acétone deutériée sur de l'ammoniac dont l'azote est de l'azote 15 suivant le schéma réactionnel:

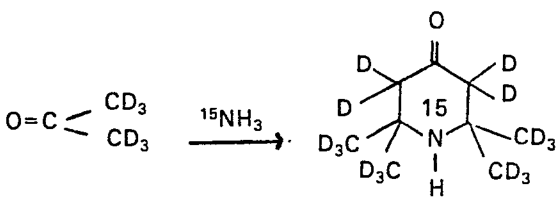


La triacétonamine deutériée, azote 15, ainsi obtenue est séparée du mélange réactionnel puis purifié.

A titre d'exemple, on va indiquer les conditions opératoires pour l'obtention de la triacétonamine deutériée, azote 15.

25 g d'acétone, 8 g de chlorure de calcium, sont introduits dans un autoclave. L'autoclave est plongé dans de l'azote liquide et mis sous vide. On y introduit alors 3,5 cm$^3$ d'ammoniac $^{15}N$ liquide. Après 48 heures à 50 °C, le produit de réaction est placé dans un ballon de 50 cm$^3$ et chauffé pendant 5 heures à 70 °C.

On recueille alors la phase liquide rouge-brun à laquelle on ajoute 0,5 cm$^3$ d'eau. L'hydrate de triacétonamine deutériée, azote 15, ainsi obtenu, précipite lorsque l'on refroidit ce liquide à −15 °C tout en agitant fortement.

La triacétonamine deutériée, azote 15, est purifiée par sublimation. On en obtient ainsi 5,1 g, soit un rendement réactionnel de 30%.

La triacétonamine deutériée, azote 15 pure, peut être aussi obtenue par chromatographie du liquide rouge sur une colonne d'alumine neutre éluée par un mélange éther de pétrole-éther.

On va maintenant décrire la fabrication des radicaux TANO $^{15}N$ deutérié et TANOL $^{15}N$ deutérié à partir de la triacétonamine deutériée, azote 15.

La fabrication du radical TANO $^{15}N$ deutérié se fait par oxydation de la triacétonamine deutériée, azote 15 par de l'eau oxygénée en présence d'acide phosphotungstique. Le radical TANO $^{15}N$ deutérié est ensuite extrait du mélange réactionnel.

L'obtention du radical TANO $^{15}N$ deutérié peut donc être représentée par le schéma réactionnel suivant:

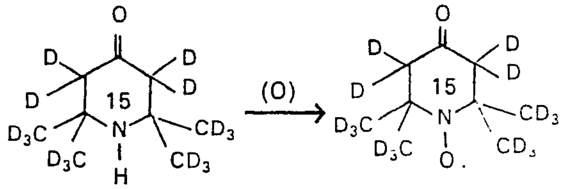


A titre d'exemple, on va indiquer les conditions opératoires d'obtention du radical TANO $^{15}N$ deutérié à partir de la triacétonamine deutériée, azote 15.

On met en solution dans 5 cm$^3$ d'eau, 1 g de triacétonamine deutériée, azote 15 obtenue comme précédemment, 10 mg d'acide phosphotungstique et 1,5 cm$^3$ d'eau oxygénée à 110 volumes. Après deux heures de réaction on extrait le radical TANO $^{15}N$ deutérié à l'éther. La phase organique est lavée à l'acide sulfurique normal, puis à l'eau, puis séchée sur sulfate de sodium. L'éther est évaporé et le radical est recristallisé dans de l'éther de pétrole. On obtient ainsi 0,75 g de radical TANO $^{15}N$ deutérié soit un rendement réactionnel de 75%.

Certains deutériums méthyléniques en «α» de la fonction cétone ayant pu s'échanger avec des protons en cours d'oxydation ou d'extraction, un échange isotopique dans l'eau lourde en milieu basique est nécessaire pour obtenir une deutériation totale.

Pour cette raison, les 0,75 g de radical TANO $^{15}N$ obtenus précédemment sont mis en solution dans 20 cm$^3$ d'eau lourde dont le pH est porté à 13 par addition de carbonate de potassium. Cette solution est agitée pendant deux heures à température ambiante, puis le radical est extrait à l'éther. La phase organique est séchée sur sulfate de sodium et l'éther est évaporé.

La fabrication du radical TANOL $^{15}N$ deutérié se fait par réduction de la fonction cétone du radical TANO $^{15}N$ deutérié dans de l'éther éthylique anhydre par du tétradeutéro-aluminate de lithium. Le produit réactionnel obtenu est hydrolysé puis purifié après avoir été séparé du mélange réactionnel.

L'obtention du radical TANOL $^{15}N$ deutérié peut donc être représentée par le schéma réactionnel suivant:

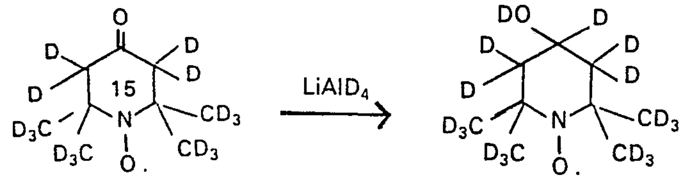


A titre d'exemple, on va indiquer les conditions opératoires d'obtention du radical TANOL $^{15}N$ deutérié à partir du TANO $^{15}N$ deutérié.

A une solution de 1 g de TANO $^{15}N$ deutérié, dans 200 cm$^3$ d'éther éthylique anhydre, on ajoute 140 mg de tétradeutéro-aluminate de lithium. Après deux heures de réaction à 0 °C, on hydrolyse par addition successive de 1 cm$^3$ d'eau,

de 1 $cm^3$ d'une solution de soude à 15% et 3 $cm^3$ d'eau. On filtre le précipité floconneux. Le filtrat est séché sur du sulfate de sodium et l'éther est évaporé. On recueille le radical TANOL $^{15}N$ deutérié avec un rendement quantitatif.

En ce qui concerne la fabrication du TANANE $^{15}N$ deutérié, celle-ci se fait par réduction de la fonction cétone de la triacétonamine deutériée, azote 15, dans du diéthylène glycol deutérié par de l'hydrazine deutériée. Sur le produit obtenu on fait alors réagir du sodium, ce qui permet d'obtenir la tétraméthyl-2,2,6,6, pipéridine deutériée.

La fonction amine de la tétraméthyl 2,2,6,6 pipéridine deutériée est ensuite oxydée dans de l'éther éthylique par de l'acide métachloroperbenzoïque. Après neutralisation de l'acide on extrait le radical TANANE $^{15}N$ deutérié après l'avoir purifié.

L'obtention du radical TANANE $^{15}N$ deutérié peut être représentée par le schéma réactionnel suivant:

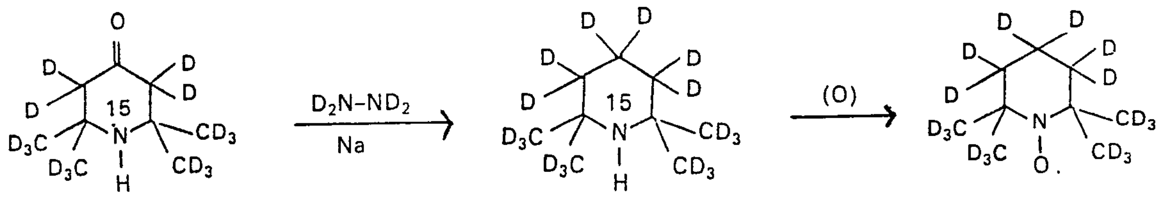


A titre d'exemple, on va indiquer les conditions opératoires d'obtention du radical TANANE $^{15}N$ deutérié.

Le réduction de la fonction cétone de la triacétonamine deutériée, azote 15 se faisant dans du diéthylène glycol deutérié par de l'hydrazine deutériée, il est nécessaire, au préalable de deutérier le diéthylène glycol et l'hydrazine.

– Préparation de l'hydrazine deutériée:

Une solution de 5 g d'hydrate d'hydrazine dans 10 $cm^3$ d'eau lourdes est portée à reflux pendant 12 heures, puis on distille l'eau. Cet échange est répété trois fois dans les mêmes conditions.

– Préparation du diéthylène glycol deutérié:

Une solution de 10 $cm^3$ de diéthylène glycol dans 10 $cm^3$ d'eau lourde est portée à reflux pendant 12 heures, puis on distille l'eau. Cet échange est répété trois fois dans les mêmes conditions.

– Obtention du radical TANANE $^{15}N$, azote 15:

A une solution de 3 g d'hydrate d'hydrazine deutériée dans 10 $cm^3$ de diéthylène glycol deutérié, dans un ballon de 50 $cm^3$ muni d'un réfrigérant et chauffé à 80 °C sur un bain d'huile, on ajoute, par petites portions pendant 2 heures, 2,5 g de triacétonamine deutériée, azote 15. Après 12 heures de réaction on remplace le réfrigérant par un pont à distiller et on élimine l'eau et l'hydrazine en excès. On ajoute ensuite, à froid, 1,5 g de sodium, puis on replace le réfrigérant et on porte le bain d'huile à 160 °C. Au bout d'une demi-heure, la tétraméthyl-2,2,6,6, pipéridine deutériée, azote 15, se sublime et commence à se déposer sur les parois du réfrigérant. Après 6 heures de réaction on obtient ainsi 1,7 g d'hydrate de tétraméthyl-2,2,6,6 pipéridine deutériée, azote 15.

Puis à une solution de 1 g d'hydrate de tétraméthyl-2,2,6,6 pipéridine deutériée, azote 15, dans 20 $cm^3$ d'éther éthylique on ajoute goutte à goutte une solution de 1,5 g d'acide métachloroperbenzoïque dans 10 $cm^3$ d'éther. Après une heure de réaction à 0 °C on neutralise l'acide métachloroperbenzoïque par une solution de soude 5N. La phase organique est lavée à l'eau, puis par quelques $cm^3$ d'acide sulfurique N pour extraire l'amine n'ayant pas réagi, relavée ensuite deux fois à l'eau, séchée sur du sulfate de sodium et évaporée lentement. On recueille ainsi 0,62 g de radical TANANE $^{15}N$ deutérié soit un rendement réactionnel de 71%.

## Revendication

Procédé de polarisation magnétique en champ faible des noyaux d'un solvant par saturation d'une raie de résonance magnétique électronique d'un radical libre à structure spectrale hyperfine dissous dans ce solvant, en magnétométrie et en gyrométrie, caractérisé en ce que le radical présente la formule développée:

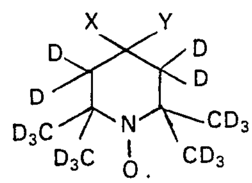

dans laquelle X représente D, Y représente D ou OD ou dans laquelle X et Y représentent O lié au cycle du radical par une double liaison.

## Patentanspruch

Verfahren zur magnetischen Polarisation im schwachen Feld von Lösungsmittelkernen durch Sättigung einer elektromagnetischen Resonanzlinie eines freien Radikals mit einer hyperfeinen Spektralstruktur, gelöst in dem Lösungsmittel mittels Magnetometrie und Gyrometrie, dadurch gekennzeichnet, dass das Radikal der nachfolgenden Formel entspricht:

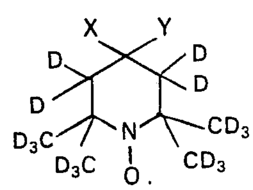

worin X die Bedeutung D hat, Y die Bedeutung D oder OD hat oder worin X und Y die Bedeutung O

haben, das an den Radikal-Zyklus über eine Doppelbindung gebunden ist.

**Claim**

Process for the weak field magnetic polarization of the nuclei of a solvent by saturation of an electronic magnetic resonance line of a free radical with a hyperfine spectral structure dissolved in said solvent in magnetometry and in gyrometry, characterized in that the radical has the developed formula:

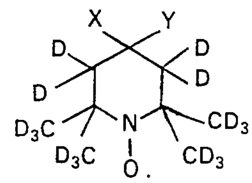

in which X represents D, Y represents D or OD, or in which X and Y represent O linked with the cycle of the radical by a double bond.

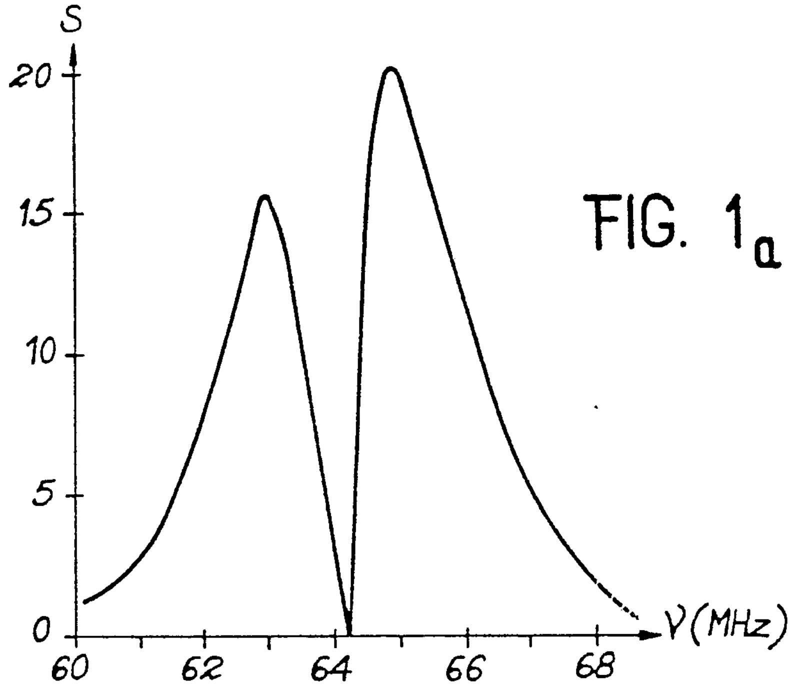


FIG. 1a

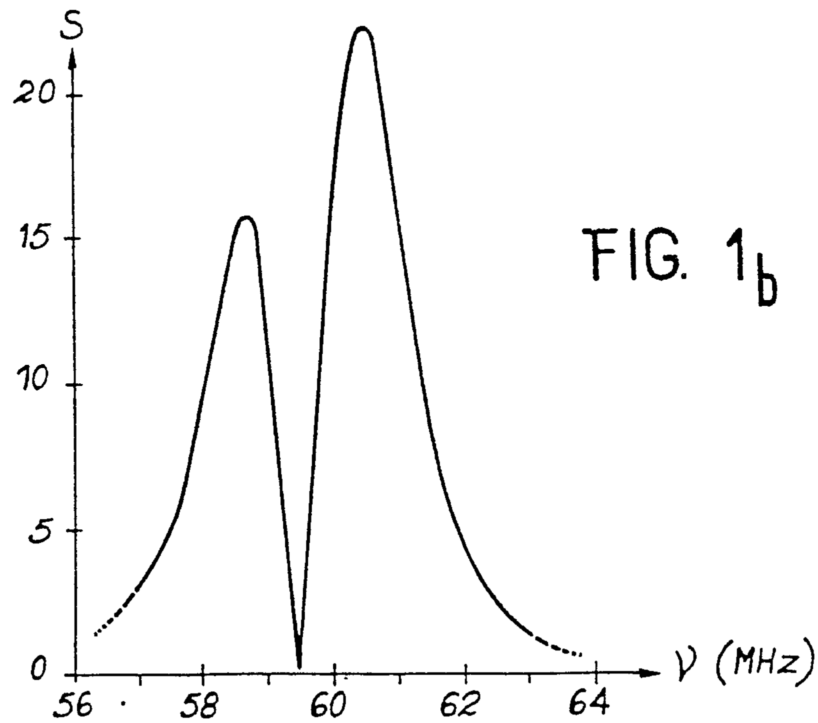


FIG. 1b

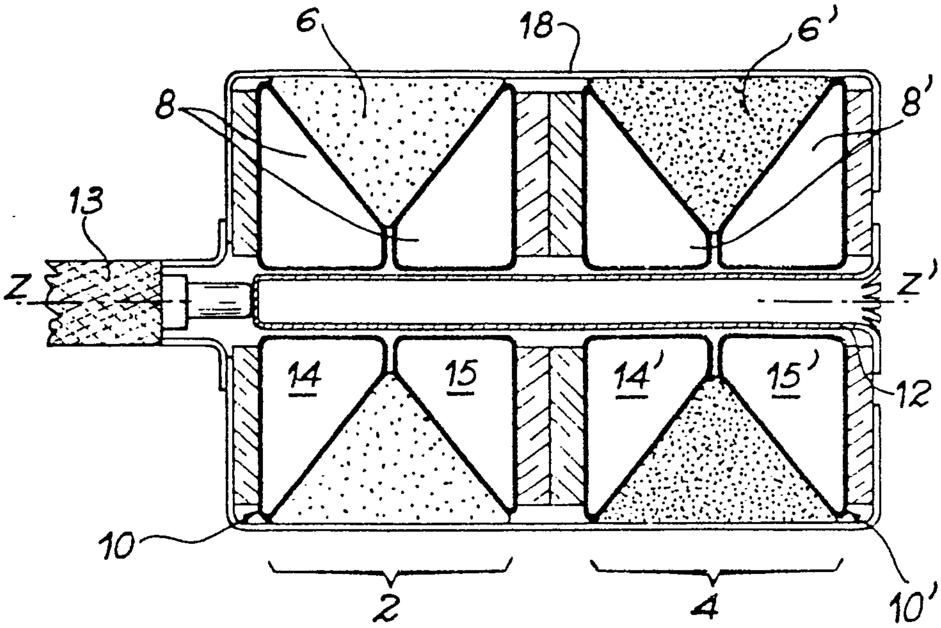


FIG. 2a

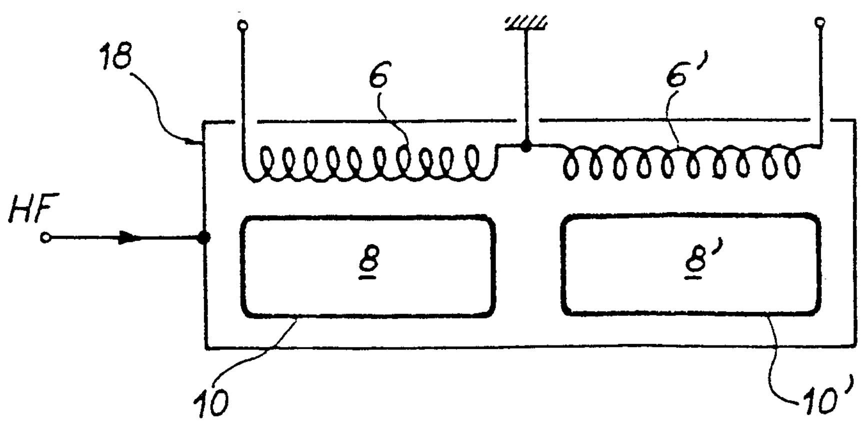


FIG. 2b

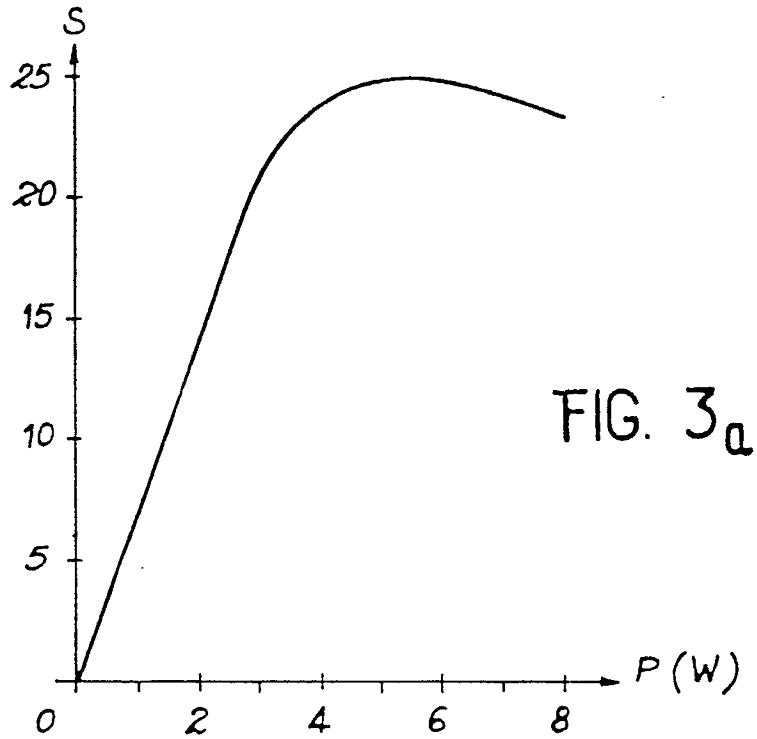


FIG. 3a

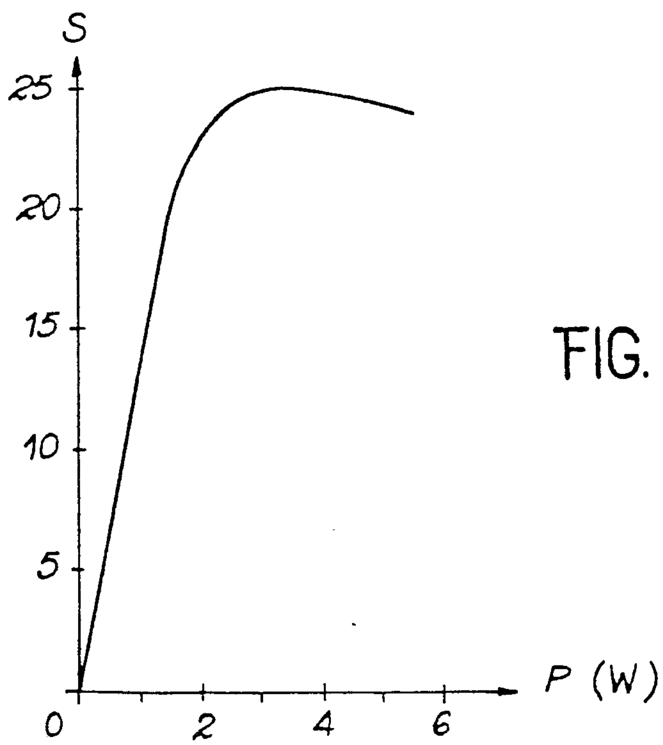


FIG. 3b